# FASCICULE DE BREVET EUROPEEN

(11) **EP 2 441 088 B1**
(45) Date de publication et mention de la délivrance du brevet: **20.07.2016**
(21) Numéro de dépôt: 10725161.3
(22) Date de dépôt: 14.06.2010
(51) Int. Cl.: H01L 23/31, H01L 23/538, H01L 21/56, H01L 23/00

(54) **PROCÉDÉ DE POSITIONNEMENT DES PUCES LORS DE LA FABRICATION D'UNE PLAQUE RECONSTITUÉE**
METHODE ZUM POSITIONIEREN VON CHIPS WÄHREND DER PRODUKTION VON EINEM REKONSTRITUERTEN WAFER
METHOD FOR POSITIONING CHIPS DURING THE PRODUCTION OF A RECONSTITUTED WAFER

(30) Priorité: 12.06.2009 FR 0902871
(43) Date de publication de la demande: 18.04.2012
(73) Titulaire: 3D Plus, 78532 Buc Cedex (FR)
(72) Inventeur: VAL, Christian, F-78470 St Remy les Chevreuse (FR)
(74) Mandataire: Henriot, Marie-Pierre
(86) Numéro de dépôt international: PCT/EP2010/058277
(87) Numéro de publication internationale: WO 2010/142804

(56) Documents cités:
- WO-A1-2009/020241
- WO-A2-02/15266
- US-A1- 2004 089 464

## Description

Le domaine de l'invention est celui de la fabrication de plaques (ou « wafers » en anglais) reconstituées qui comprennent des puces encapsulées dans une résine, ces puces ayant en général été préalablement testées.

La solution la plus couramment mise en oeuvre pour réaliser une plaque reconstituée consiste tout d'abord à découper les plaques sur lesquelles les puces ont été fabriquées pour obtenir des puces individuelles, une plaque produisant un premier type de puces ou « chips » identiques entre elles, une autre plaque produisant un autre type de puces, etc. On désigne par puce un composant électronique actif tel qu'une puce nue ou un composant passif (condensateurs, résistances, transformateurs ou inductances, ...) ou un MEMS, acronyme de l'expression anglo-saxonne « Micro Electro Mechanical System ». Généralement, ces puces sont alors sélectionnées après avoir été testées et souvent désignées « Known Good Die ».

Par ailleurs le support destiné à recevoir les puces testées est préparé : il s'agit d'un support rigide adhésif.

Les différents types de puces testées, qui présentent des plots de connexion sur une face dite face active ou face avant, sont alors prélevées et positionnées face avant sur ce support adhésif au moyen par exemple d'une machine « pick-and-place » pour former des motifs de puces généralement semblables les uns aux autres. On désigne par motif de puces, un groupe de différentes puces destinées à former un élément électronique.

Puis les puces sont moulées dans une résine polymère de type Epoxy, qui est ensuite polymérisée afin de les solidariser.

Le support adhésif est alors retiré.

Une étape de redistribution des plots des puces sur des pistes destinées à la future interconnexion des puces est assurée en formant sur la face avant de la puce, une couche de redistribution ou RDL acronyme de l'expression anglo-saxonne « ReDistribution Layer » comportant généralement elle-même un empilement de couches ; de manière connue, les pistes de cette couche RDL qui sont en TiW/Cu ou en TiPd/Au par exemple, sont formées sur une couche diélectrique déposée à la place du support adhésif, par trempage ou par centrifugation.

On peut résumer ces différentes étapes par le diagramme suivant :
1 Découpe de la plaque pour obtenir des puces individuelles
2 Préparation du support rigide adhésif
3 Report des puces découpées sur le support rigide adhésif
4 Moulage des puces dans de la résine et polymérisation
5 Retrait du support adhésif
6 Redistribution des couches sur la plaque reconstituée (RDL).

La plaque ainsi reconstituée qui ne comporte pas de puces défectueuses peut alors être découpée selon les motifs, pour obtenir des micro boîtiers plastiques ; elle peut aussi être empilée sur d'autres plaques reconstituées, et électriquement connectée à ces plaques selon différents procédés connus, l'empilement étant ensuite découpé pour obtenir des modules électroniques à trois dimensions ou 3D.

L'encapsulation des puces lors de l'étape 4 comprend :
- une étape de dépôt de la résine (par coulage ou par moulage dit en compression), autour et éventuellement sur les puces collées sur le support adhésif, de manière à remplir les espaces inter-puces,
- une étape de polymérisation de la résine pour la durcir et ainsi former un substrat rigide et manipulable dans lequel sont fixées les puces, le substrat adhésif pouvant alors être retiré.

Un inconvénient notoire est le déplacement des puces lors du dépôt de la résine et/ou lors de sa polymérisation avec pour conséquence que les plots des puces ne coïncideront plus avec les pistes de la couche de redistribution (couche RDL) lors de l'étape 6. Les micro déplacements des puces par rapport à la position prévue sont dus à :
A) l'imprécision de positionnement des puces sur le support adhésif, qui est de l'ordre de 5 µm avec des équipements « pick-and-place » récents fonctionnant à grande vitesse,
B) la dilatation réversible mais très élevée du support adhésif aux alentours de 100 ppm/°C,
C) le retrait irréversible de la résine lors de la polymérisation de l'ordre de quelques 1000 ppm/°C,
D) la dilatation irréversible de la résine après polymérisation d'environ 16 à 17 ppm/°C.

Il en résulte des micro déplacements plus ou moins isotropes et prévisibles, typiquement compris entre quelques µm et quelques dizaines de µm, ce qui peut excéder les tolérances de positionnement (par rapport à la couche RDL) requises après moulage, qui sont typiquement de l'ordre de 10 µm.

Une solution consiste à étudier et enregistrer ces micro déplacements préalablement puis à les anticiper lors du positionnement des puces lorsqu'elles sont reportées sur le support adhésif. Une des limites de cette technique provient de ce que les micro déplacements ne sont pas tous prévisibles, notamment ceux des différents types de puces au sein d'un même motif.

Une autre solution consiste à modifier les masques utilisés pour réaliser la couche RDL.

Le but de l'invention est de pallier cet inconvénient de déplacement des puces lors de leur moulage dans de la résine et lors de la polymérisation de cette résine.

La solution proposée est basée sur la réalisation de l'étape de formation des couches de redistribution (couche RDL) avant celle du moulage de la résine, ce qui permet de supprimer les causes B, C et D de déplacements des puces.

Plus précisément l'invention a pour objet un procédé de fabrication d'une plaque reconstituée qui comporte des puces présentant des plots de connexion, ce procédé comprenant les étapes suivantes de :
- fabrication d'une première plaque de puces,
   caractérisé en ce qu'il comprend en outre les étapes suivantes :
- réalisation sur cette plaque d'un empilement d'au moins une couche de redistribution des plots des puces sur des pistes conductrices destinées à l'interconnexion des puces, cet empilement étant désigné couche RDL principale,
- découpe de cette première plaque pour obtenir des puces individuelles munies chacune de leur couche RDL,
- report des puces individuelles avec leur couche RDL sur un support suffisamment rigide pour rester plan lors des étapes suivantes, et muni d'une couche de colle, avec la couche RDL sur la couche de colle,
- dépôt d'une résine pour encapsuler les puces,
- polymérisation de la résine,
- retrait du support rigide,
- dépôt d'une seule couche de redistribution dite mini RDL pour relier les pistes conductrices de la couche RDL principale jusqu'à des contacts d'interconnexion, à travers des ouvertures pratiquées dans la couche de colle, la plaque comportant les puces avec leur couche de RDL, la résine polymérisée et la Mini RDL étant la plaque reconstituée.

Ce procédé permet de maintenir les puces à l'endroit où elles ont été positionnées, pendant et après leur moulage dans de la résine.

Bien sûr, la couche RDL qui est formée en deux étapes (RDL principale + mini RDL) n'est pas la même que celle du procédé décrit en préambule mais elle assure la même fonction.

Il comprend en outre une étape de test et/ou de déverminage des puces avant leur report sur le support rigide.

Selon une caractéristique de l'invention, les ouvertures dans la couche de colle sont réalisées avant le report des puces sur le support rigide.

Selon une variante, les ouvertures dans la couche de colle sont réalisées après l'étape de retrait du support.

D'autres caractéristiques et avantages de l'invention apparaîtront à la lecture de la description détaillée qui suit, faite à titre d'exemple non limitatif et en référence aux dessins annexés dans lesquels :
la figure 1 représente schématiquement vue en coupe une plaque, comportant des puces avec leur couche RDL et prêtes à être découpées,
la figure 2 représente schématiquement vu en coupe un support avec sa couche de colle,
la figure 3 représente schématiquement vue en coupe une plaque reconstituée après report des puces,
la figure 4a représente schématiquement vue en coupe une plaque reconstituée après moulage des puces dans de la résine et polymérisation de cette résine, la figure 4b représentant cette plaque polie,
la figure 5 représente schématiquement vue en coupe une plaque reconstituée et polymérisée, après retrait du support,
la figure 6 représente schématiquement vue en coupe une plaque reconstituée et polymérisée, après retrait du support et réalisation d'ouvertures dans la colle,
la figure 7 représente schématiquement vue en coupe la plaque reconstituée de la figure 6 après réalisation de la mini couche de RDL,
la figure 8 représente schématiquement différentes formes de conducteurs.

D'une figure à l'autre, les mêmes éléments sont repérés par les mêmes références. La référence 100 désigne la plaque reconstituée au cours des différentes étapes de sa fabrication.

Le procédé selon l'invention est basé sur la réalisation d'une couche RDL principale avant le moulage des puces dans de la résine. Les étapes du procédé selon l'invention peuvent être résumées dans le diagramme suivant :
1 Redistribution des couches (RDL principale) sur la plaque d'origine (ou première plaque) puis découpe de la plaque pour obtenir des puces individuelles
2 Préparation d'un support rigide avec sa couche de colle
3 Report des puces découpées avec leur RDL principale sur ce support et sa couche de colle
4 Moulage des puces et polymérisation de la résine
5 Retrait du support
6 Gravure éventuelle des ouvertures dans la couche de colle
7 Redistribution d'une seule couche d'interconnexion (Mini RDL).

Comme on peut le constater, la redistribution des conducteurs sur les plots des puces (c'est-à-dire la réalisation de la couche RDL principale) est faite au tout début sur les plaques de base (ou premières plaques) donc avec la précision habituelle obtenue lors de la fabrication de celles-ci. Les puces n'étant pas dans de la résine mais partie intégrante de la plaque en silicium, il n'y a absolument aucune dérive de celles-ci et les causes B, C et D de déplacements n'existent pas à ce stade. Cela permet de reporter presque totalement la complexité de la RDL vers la plaque en silicium (ou première plaque) au lieu de la réaliser sur la plaque reconstituée.

Cette opération de réalisation de la couche RDL principale est parfaitement maîtrisée et peut être effectuée par le fabricant de puces alors que dans le procédé précédent elle était réalisée après et donc par un autre fabricant qui ne possède pas nécessairement le même niveau d'équipements.

Enfin, les causes B, C et D vont disparaître puisque les puces vont être collées sur une couche très fine de colle elle-même déposée sur un support rigide ayant sensiblement la même dilatation que la résine qui sera utilisée.

On va à présent décrire plus en détail les différentes étapes.

L'étape de réalisation de la couche RDL principale 14 est une opération classique. Le nombre de couches métalliques varie typiquement de 1 à 4 par exemple selon la complexité du routage permettant de tracer un conducteur 12 depuis le plot 10 de la puce 1 jusqu'à la périphérie de celle-ci et qui n'aboutit à rien, dans le cas où l'on souhaite ultérieurement empiler les plaques reconstituées et les interconnecter par les côtés, comme déjà décrit dans des brevets précédents. S'il n'est pas envisagé d'empiler ces puces comme dans le cas d'un module électronique à deux dimensions (2D), le routage ne nécessite pas de tracer tous les conducteurs jusqu'à la périphérie : c'est une possibilité parmi d'autres.

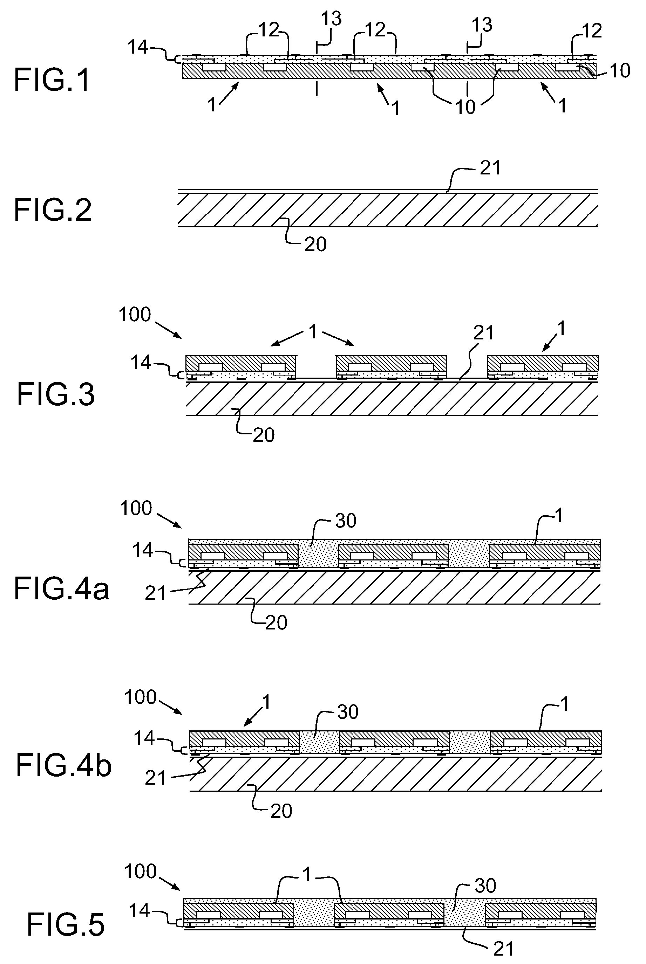

Ces conducteurs 12 ont traditionnellement la forme de pistes de largeur quasiment constante sur toute la longueur de la piste. La largeur de ces conducteurs reliant chaque plot de la puce avec les bords de celle-ci ou avec d'autres plots d'interconnexion, peut être très faible par exemple de 1 à 10 µm puisque la RDL principale est effectuée sur la plaque non découpée. Un exemple d'une telle plaque est montré figure 1. Après la réalisation de la RDL principale 14, les plaques sont classiquement découpées selon des chemins de découpe 13. A l'issue de cette étape, on dispose donc de puces 1 avec leur couche de RDL principale 14 qui, de préférence auront été testées au moyen de cartes à pointes comme l'ensemble des puces.

Pour l'étape de préparation du support, on choisit un matériau permettant d'obtenir un support 20 suffisamment rigide pour rester plan lorsque la plaque reconstituée sera polymérisée. On choisit un matériau ayant sensiblement le même coefficient de dilatation que la résine de moulage et pouvant facilement être éliminé. Un matériau métallique tel que le cuivre qui peut facilement être éliminé par dissolution chimique répond à ces spécifications : il est bien approprié puisqu'il a un coefficient de dilatation de 17ppm/°C identique à celui de la résine. On peut aussi utiliser un alliage de Kovar qui a un coefficient de dilatation de 6 à 7 ppm, voire même du silicium qui a un coefficient de dilatation de 3 ppm, ou du verre.

Le support 20 peut être circulaire et avoir un diamètre compatible des équipements de semi conducteurs égal à 150, 200, 300 mm par exemple ; il peut être rectangulaire ou carré avec des dimensions du même ordre de façon à ce que toutes les opérations soient collectives. L'épaisseur d'un support en cuivre est selon les dimensions surfaciques comprise entre 75 et 500 µm.

La colle 21 est ensuite déposée en couche mince par centrifugation classique par exemple, avec une épaisseur de 2 à 10 µm. Il s'agit d'une colle à collage irréversible par opposition aux colles de type « peau collante » qui permettent de coller puis de décoller les puces sans les abîmer. La colle utilisée est par exemple de type Epoxy. Ce dépôt peut être réalisé par seringue ou par jet d'encre ou par sérigraphie ou par pochoir, ou par tout autre moyen connu de l'homme du métier. On considère alors 2 cas :
- Cas d'une colle photosensible comme par exemple la résine époxy « SU8 », ayant un pouvoir collant avant complète polymérisation. Ce matériau est alors photogravé (par exemple après insolation UV) après un premier traitement thermique qui le rend pseudo solide et pâteux. Après insolation et développement il est gravé par gravure laser ou par gravure par plasma et l'on obtient des ouvertures aux endroits désirés.
- Cas d'une colle non photosensible. Elle est déposée de la même façon sur une épaisseur identique et est pré-polymérisée de façon à lui conserver son pouvoir collant. A ce stade, les ouvertures dans la colle peuvent être effectuées par gravure laser ou par gravure par plasma.

On montre figure 2 un exemple d'un tel support 20 avec sa couche de colle 21.

L'étape de report sur ce support collant des puces découpées avec leur RDL est une opération classique dont le résultat est illustré figure 3. Ces puces sont reportées de préférence après avoir été testées et/ou déverminées. Comme indiqué dans le préambule, différentes types de puces peuvent être reportés de façon à réaliser des motifs.

L'étape de moulage de la résine 30 (déposée par exemple par un procédé de coulage) et de polymérisation sont également des opérations classiques. De préférence, la température de transition de la colle 21 doit être supérieure à la température de polymérisation de la résine de moulage 30 de manière à ne pas perdre ses propriétés de maintien en position de chaque puce 1 durant la polymérisation de la résine de moulage.

A l'issue de la polymérisation, les puces 1 sont restées positionnées à l'emplacement déterminé par la pose automatique et avec la précision inhérente à celle-ci soit environ 5µm. La plaque 100 à ce stade est montrée figure 4a. Elle est éventuellement polie pour être amincie, jusqu'à laisser apparaître la face arrière des puces (c'est-à-dire la face sans plots) comme représenté figure 4b.

L'étape de retrait du support rigide est par exemple réalisée par dissolution chimique ou par abrasion. Après moulage, la plaque reconstituée 100 est parfaitement manipulable et la dissolution chimique du cuivre (si ce matériau a été choisi) est une opération très connue et rapide. On rappelle que l'épaisseur du support en cuivre est comprise entre 75 et 500µm.

Après dissolution, il ne reste que la colle 21 comme on peut le voir figure 5.

Cette colle 21 présente éventuellement des ouvertures 22 réalisées par photogravure durant l'étape de préparation du support avec colle. Lorsque les ouvertures 22 dans la colle n'ont pas été réalisées lors de la préparation du support avec colle, la colle 21 utilisée n'étant par exemple pas photogravable, elles peuvent être réalisées à ce stade, selon 2 approches :
- Gravure par plasma avec oxygène de façon à « brûler » la colle 21 au droit de l'ouverture 22 définie par un masque. Cette technique est utilisée pour graver industriellement les circuits imprimés haute définition.
- Gravure par laser au moyen d'un laser type YAG ou excimère.
Ce procédé est déjà utilisé pour la fabrication des circuits imprimés.

La gravure de ces ouvertures 22 permet de faire réapparaître tout ou partie des conducteurs 12 reliant les plots 10 de la puce individuelle à des contacts d'interconnexion ; l'opération dite « Mini RDL » peut alors avoir lieu.

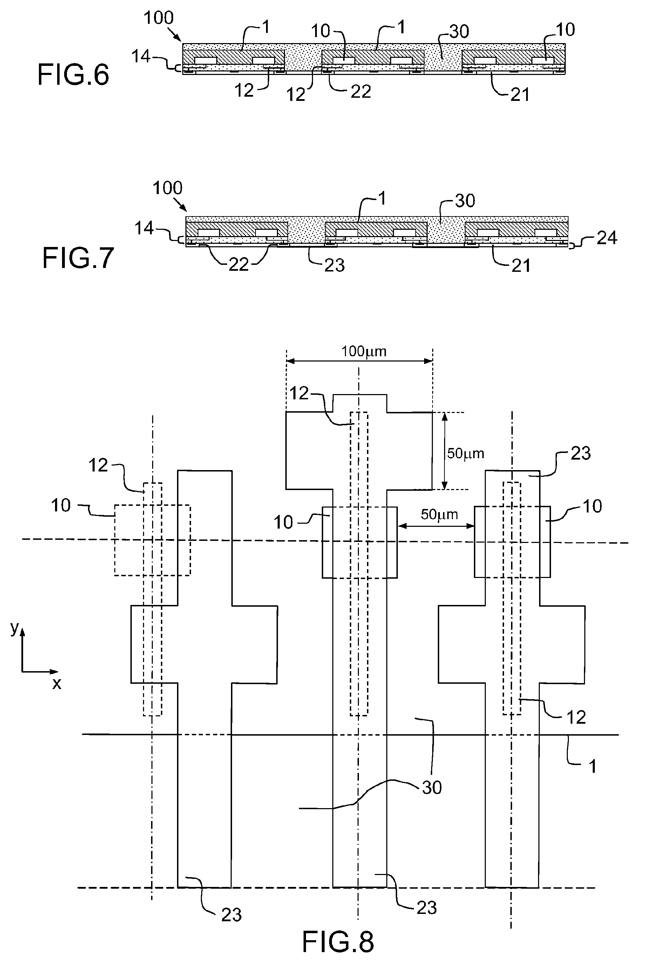

La plaque 100 obtenue à l'issue de cette étape est montrée figure 6.

L'étape de redistribution d'une seule couche conductrice dite « Mini RDL » 24 dont le résultat est montré figure 7, est simple à réaliser. Un seul dépôt métallique en cuivre par exemple est suffisant puisqu'il s'agit de connecter des conducteurs 12 issus de la RDL principale donc parfaitement positionnés avec les conducteurs 23 de cette Mini RDL afin de les amener à la périphérie de la résine entourant les puces s'il est prévu de les empiler ou plus généralement de les amener au point d'interconnexion désiré.

La forme de ces conducteurs 23 peut être adaptée pour compenser non plus les mouvements des puces dus aux dilatations différentielles de la résine et de la couche collante puisqu'elles ont été supprimées mais les faibles imprécisions de pose des puces munies de leur RDL principale, que l'on a estimées à environ 5µm. Comme on l'a vu plus haut, les pistes 12 de la RDL principale, dites premières pistes sont de préférence très fines, d'une largeur comprise entre 1 et 10 µm. Les pistes 23 de la Mini RDL dites secondes pistes, doivent recouvrir totalement ou partiellement les premières pistes. Des conducteurs 23 de plus grande largeur (10 à 50µm) que ceux de la RDL principale sont avantageusement réalisés afin de recouvrir les conducteurs 12 fins issus de la RDL principale effectuée au niveau de la plaque. La forme des conducteurs permet aussi de compenser ces variations de positionnement : la figure 8 présentent des formes appropriées à ce genre de corrections en X et en Y, ces directions étant considérées dans la plan de la plaque. Il s'agit par exemple de forme en T ou en croix latine, la barre transversale du T ou de la croix permettant d'établir le contact entre la première piste 12 et la seconde 23 même lorsque les autres parties sont décalées comme illustré sur la figure de gauche de la figure 8 ; les figures du centre et à droite montrent des conducteurs 12 et 23 non décalés les uns par rapport aux autres.

Cette différence de largeur entre les pistes de la RDL principale et celles de la mini RDL permet une grande tolérance de recouvrement de ces pistes.

Pour réaliser des modules 3D (à trois dimensions), ces plaques reconstituées 100 sont empilées et après empilage, les conducteurs 23 sont connectés verticalement au moyen de procédés connus.

La plaque reconstituée 100 peut aussi être découpée pour obtenir des micro boîtiers à deux dimensions.

## Revendications

1. Procédé de fabrication d'une plaque reconstituée (100) qui comporte des puces (1) présentant des plots de connexion (10), ce procédé comprenant dans l'ordre les étapes suivantes de :
- fabrication d'une première plaque de puces (1),
**caractérisé en ce qu'**il comprend en outre les étapes suivantes :
- réalisation sur cette plaque d'un empilement d'au moins une couche métallique de redistribution des plots (10) des puces sur des pistes conductrices (12) joignant les plots (10) des puces jusqu'à la périphérie des puces, destinées à l'interconnexion des puces, cet empilement étant désigné couche RDL principale (14),
- découpe de cette plaque pour obtenir des puces (1) individuelles munies chacune de leur couche RDL (14),
- report des puces individuelles avec leur couche RDL (14) sur un support suffisamment rigide (20) pour rester plan lors des étapes suivantes, et muni d'une couche de colle (21), avec la couche RDL (14) sur la couche de colle (21),
- dépôt d'une résine (30) pour encapsuler les puces (1),
- polymérisation de la résine,
- retrait du support rigide (20),
- dépôt d'une seule couche de redistribution dite mini RDL (24) pour relier les pistes conductrices de la couche RDL (14) principale jusqu'à des contacts d'interconnexion, à travers des ouvertures (22) pratiquées dans la couche de colle (21) avant le report des puces sur le support rigide et au moyen de conducteurs (23) plus larges que les pistes conductrices (12), la plaque comportant la résine polymérisée, les puces avec leur couche de RDL, et la Mini RDL étant la plaque reconstituée (100).

2. Procédé de fabrication d'une plaque reconstituée (100) selon la revendication précédente, **caractérisé en ce que** la couche RDL principale (14) comporte 2 ou 3 ou 4 couches de redistribution des plots.

3. Procédé de fabrication d'une plaque reconstituée (100) selon l'une quelconque des revendications précédentes, **caractérisé en ce qu'**il comprend en outre une étape de test et/ou de déverminage des puces (1) avant leur report sur le support rigide (20).

4. Procédé de fabrication d'une plaque reconstituée (100) selon l'une quelconque des revendications précédentes, **caractérisé en ce que** des conducteurs (23) de la Mini RDL (24) ont une forme en T ou en croix latine.

5. Procédé de fabrication d'une plaque reconstituée (100) selon l'une quelconque des revendications précédentes, **caractérisé en ce que** la couche de colle (21) est dans un matériau à collage irréversible.

## Patentansprüche

1. Verfahren zur Herstellung eines rekonstruierten Wafers (100), der Chips (1) mit Kontaktstellen (10) umfasst, wobei das Verfahren die folgenden Schritte der Reihe nach beinhaltet:
- Herstellen eines ersten Chipwafers (1),
**dadurch gekennzeichnet, dass** es ferner die folgenden Schritte beinhaltet:
- Realisieren, auf diesem Wafer, eines Stapels von wenigstens einer metallischen Schicht zum Umverteilen von Kontaktstellen (10) der Chips auf Leiterbahnen (12), die die Kontaktstellen (10) von Chips bis zur Peripherie der Chips verbinden, zum Verbinden der Chips miteinander, wobei dieser Stapel als Haupt-RDL-Schicht (14) bezeichnet wird,
- Schneiden dieses Wafers, um individuelle Chips (1) zu erhalten, die jeweils mit ihrer RDL-Schicht (14) versehen sind,
- Übertragen einzelner Chips mit ihrer RDL-Schicht (14) auf einem ausreichend starren Substrat (20), so dass es bei den folgenden Schritten flach liegt, und versehen mit einer Klebstoffschicht (21), mit der RDL-Schicht (14) auf der Klebstoffschicht (21),
- Absetzen eines Harzes (30) zum Verkapseln der Chips (1),
- Polymerisieren des Harzes,
- Entfernen des starren Substrats (20),
- Absetzen einer einzigen Umverteilungsschicht, Mini-RDL (24) genannt, zum Verbinden der Leiterbahnen der Haupt-RDL-Schicht (14) bis zu den Verbindungskontakten durch Öffnungen (22) in der Klebstoffschicht (21) vor dem Übertragen der Chips auf dem starren Substrat, und mittels Leitern (23), die breiter sind als die Leiterbahnen (12), wobei der Wafer das polymerisierte Harz, die Chips mit ihrer RDL-Schicht und die Mini-RDL-Schicht als den rekonstruierten Wafer (100) umfasst.

2. Verfahren zur Herstellung eines rekonstruierten Wafers (100) nach dem vorherigen Anspruch, **dadurch gekennzeichnet, dass** die Haupt-RDL-Schicht (14) 2 oder 3 oder 4 Kontaktstellenumverteilungsschichten umfasst.

3. Verfahren zur Herstellung eines rekonstruierten Wafers (100) nach einem der vorherigen Ansprüche, **dadurch gekennzeichnet, dass** es ferner einen Schritt des Prüfens und/oder des Brennens von Chips (1) vor ihrem Übertragen auf dem starren Substrat (20) beinhaltet.

4. Verfahren zur Herstellung eines rekonstruierten Wafers (100) nach einem der vorherigen Ansprüche, **dadurch gekennzeichnet, dass** die Leiter (23) der Mini-RDL-Schicht (24) die Form eines T oder eines lateinischen Kreuzes haben.

5. Verfahren zur Herstellung eines rekonstruierten Wafers (100) nach einem der vorherigen Ansprüche, **dadurch gekennzeichnet, dass** die Klebstoffschicht (21) aus einem irreversiblen Klebstoff besteht.

## Claims

1. Method for producing a reconstituted plate (100) which comprises chips (1) which have connection pins (10), this method comprising in sequence the following steps of:
- producing a first plate of chips (1),
**characterised in that** it further comprises the following steps:
- producing on this plate a stack of at least one metal layer for redistribution of the pins (10) of the chips on conductive tracks (12) which connect the pins (10) of the chips as far as the periphery of the chips and which are intended to interconnect the chips, this stack being referred to as the main RDL layer (14),
- cutting this plate in order to obtain individual chips (1) which are each provided with their RDL layer (14),
- transferring the individual chips with their RDL layer (14) on a support (20) which is sufficiently rigid to remain flat during the following steps and which is provided with a layer of adhesive (21), with the RDL layer (14) on the adhesive layer (21),
- depositing a resin (30) in order to encapsulate the chips (1),
- polymerisation of the resin,
- removal of the rigid support (20),
- depositing a single redistribution layer referred to as a mini RDL (24) in order to connect the conductive tracks of the main RDL layer (14) as far as the interconnection contacts, via openings (22) which are formed in the layer of adhesive (21) before the chips are transferred on the rigid support and using conductors (23) which are wider than the conductive tracks (12), the plate comprising the polymerised resin, the chips with their RDL layer, and the mini RDL being the reconstituted plate (100).

2. Method for producing a reconstituted plate (100) according to the preceding claim, **characterised in that** the main RDL layer (14) comprises 2 or 3 or 4 layers for redistribution of the pins.

3. Method for producing a reconstituted plate (100) according to either of the preceding claims, **characterised in that** it further comprises a step of testing and/or debugging of the chips (1) before they are transferred on the rigid support (20).

4. Method for producing a reconstituted plate (100) according to any one of the preceding claims, **characterised in that** conductors (23) of the mini RDL (24) are T-shaped or in the form of a Latin cross.

5. Method for producing a reconstituted plate (100) according to any one of the preceding claims, **characterised in that** the adhesive layer (21) is of a material with irreversible adhesion.
